(19) Europäisches Patentamt
European Patent Office
Office européen des brevets

(11) **EP 4 191 664 A1**

(12) **EUROPEAN PATENT APPLICATION**
published in accordance with Art. 153(4) EPC

(43) Date of publication:
**07.06.2023 Bulletin 2023/23**

(21) Application number: **21875538.7**

(22) Date of filing: **27.09.2021**

(51) International Patent Classification (IPC):
**H01L 23/36** (2006.01)   **H01L 23/373** (2006.01)

(52) Cooperative Patent Classification (CPC):
**H01L 23/36; H01L 23/373**

(86) International application number:
**PCT/JP2021/035424**

(87) International publication number:
**WO 2022/071236 (07.04.2022 Gazette 2022/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **29.09.2020 JP 2020163279**

(71) Applicant: **Denka Company Limited**
**Tokyo 103-8338 (JP)**

(72) Inventors:
• **MINAKATA, Yoshitaka**
**Tokyo 103-8338 (JP)**

• **WAKUDA, Yusuke**
**Tokyo 103-8338 (JP)**
• **KANEKO, Masahide**
**Tokyo 103-8338 (JP)**
• **SAKAGUCHI, Shinya**
**Tokyo 103-8338 (JP)**
• **YAMAGUCHI, Tomoya**
**Tokyo 103-8338 (JP)**

(74) Representative: **Hoffmann Eitle**
**Patent- und Rechtsanwälte PartmbB**
**Arabellastraße 30**
**81925 München (DE)**

(54) **COMPOSITE SHEET AND METHOD FOR MANUFACTURING SAME, AND LAYERED BODY AND METHOD FOR MANUFACTURING SAME**

(57)    A composite sheet 10 includes porous a nitride sintered body 20 having a thickness of less than 2 mm and resins filled in pores of the nitride sintered body 20, and has a main surface 10a (10b) having a maximum height roughness Rz of less than 20 $\mu$m. A method for manufacturing the composite sheet 10 includes an impregnating step of impregnating pores of a porous the nitride sintered body 20 having a thickness of less than 2 mm with a resin composition, a smoothing step of smoothing the resin composition attached to a main surface of the nitride sintered body 20 to obtain a resin-impregnated body in which a part of the main surface is exposed, and a curing step of heating the resin-impregnated body to cure or semi-cure the resin composition impregnated in the pores to obtain the composite sheet 10.

*Fig.1*

EP 4 191 664 A1

## Description

### Technical Field

The present disclosure relates to a composite sheet and a manufacturing method thereof, and a laminate and a manufacturing method thereof.

### Background Art

In components such as power devices, transistors, thyristors, and CPUs efficiently dissipation of heat generated during use thereof is required. In response to such demands, attempts have been made to increase thermal conductivity of an insulating layer of a printed wiring board on which an electronic component is mounted, and to attach the electronic component or the printed wiring board to a heat sink via thermal interface materials having electrical insulating properties. For such an insulating layer and thermal interface materials, a composite composed of a resin and ceramics such as boron nitride is used as a heat dissipation member.

As such a composite, a composite obtained by impregnating a porous ceramic sintered body (for example, a boron nitride sintered body) with a resin has been studied (for example, see Patent Literature 1). In addition, in a laminate including a circuit board and a resin impregnated boron nitride sintered body, direct contact between primary particles constituting the boron nitride sintered body and the circuit board has been studied to reduce thermal resistance of the laminate and improve heat dissipation (for example, see Patent Literature 2).

### Citation List

### Patent Literature

Patent Literature 1: PCT International Publication No. WO2014/196496
Patent Literature 2: Japanese Unexamined Patent Publication No. 2016-103611

### Summary of Invention

### Technical Problem

With recent high integration of circuits in semiconductor devices and the like, each component is required to be miniaturized and to have excellent heat dissipation characteristics. In order for the heat dissipation member to exhibit sufficient heat dissipation performance, it is considered necessary to increase adhesion to other members and reduce thermal resistance.

The present disclosure provides a composite sheet excellent in adhesion to other members and capable of reducing thermal resistance, and a manufacturing method of the composite sheet. Further, the present disclosure provides a laminate capable of reducing thermal resistance in a lamination direction by using such a composite sheet, and a manufacturing method of the laminate.

### Solution to Problem

According to an aspect of the present disclosure, there is provided a composite sheet including: a porous nitride sintered body having a thickness of less than 2 mm; and resins filled in pores of the nitride sintered body, wherein the composite sheet includes a main surface having a maximum height roughness Rz of less than 20 $\mu$m. In such a composite sheet, since the maximum height roughness Rz on the main surface is small, the generation of a gap is prevented when the composite sheet is connected to another member, and the nitride sintered body and the other member can be sufficiently brought into close contact with each other. Therefore, the composite sheet can reduce the thermal resistance at the contact interface even when the contact area with other members is reduced due to the reduction in size.

The filling rate of the resin in the pores of the nitride sintered body may be 85 % by volume or more. By having such a high filling rate, it is possible to reduce the amount of deformation when bonding to another member by heating and pressing. Therefore, the dimensional stability can be sufficiently enhanced. In addition, in a case where the resin filled in the pores is a semi-cured product, since the filling rate of the resin is sufficiently high, when the composite sheet is bonded to another member by heating and pressing, the resin component is sufficiently exuded from the inside of the composite sheet. The resin component exuded in this manner contributes to the improvement of the adhesion, and the thermal resistance can be further reduced.

The nitride sintered body may contain a boron nitride sintered body. Boron nitride has high thermal conductivity, insulation, and the like. Therefore, the composite sheet containing the boron nitride sintered body can be suitably used as a component of semiconductor devices or the like.

According to an aspect of the present disclosure, there is provided a laminate including the above-described composite sheet and a metal laminated to each other. Since the laminate includes the above-described composite sheet, the adhesion between the composite sheet and the metal sheets is excellent. Therefore, the laminate can reduce thermal resistance.

According to an aspect of the present disclosure, there is provided an impregnating step a method for manufacturing a composite sheet, the method including: an impregnating step of impregnating pores of a porous nitride sintered body having a thickness less than 2 mm with a resin composition; a smoothing step of smoothing the resin composition adhering to a main surface of the nitride sintered body to obtain a resin-impregnated body in which a portion of the main surface is exposed; and a curing step of heating the resin-impregnated body to cure or semi-cure the resin composition impregnated in the pores to obtain the composite sheet.

In the above-described manufacturing method, since the pores of the porous nitride sintered body having a thickness of less than 2 mm are impregnated with the resin composition, it is possible to obtain a composite sheet in which the pores of the nitride sintered body are sufficiently filled with the resin component. In addition, since the resin composition adhering to the main surface of the nitride sintered body is smoothed and a portion of the main surface is exposed, the nitride sintered body and another member may be sufficiently adhered to each other. Therefore, the composite sheet obtained by the manufacturing method can reduce the thermal resistance at the contact interface even when the contact area with another member is reduced due to the reduction in size.

In the smoothing step, the resin composition adhering to the main surface of the nitride sintered body may be smoothed using at least one selected from a group consisting of a leveling member, a polishing member, a polishing apparatus, hot water, a solvent compatible with the resin composition, and hot air. Accordingly, the main surface of the nitride sintered body may be sufficiently exposed to form a smooth main surface. Therefore, the adhesion between the nitride sintered body and another member can be further improved, and the thermal resistance can be further reduced.

In the curing step, a composite sheet having a main surface having a maximum height roughness Rz of less than 20 $\mu$m may be obtained. In such a composite sheet, since the maximum height roughness Rz in the main surface is small, it is possible to prevent generating a gap when the composite sheet is connected to another member and to sufficiently bring the nitride sintered body into close contact with the other member.

The filling rate of the resin of the composite sheet obtained in the curing step may be 85 % by volume or more. By having such a high filling rate, it is possible to reduce the amount of deformation when bonding to another member by heating and pressing. Therefore, the dimensional stability can be sufficiently enhanced. In addition, in a case where the resin filled in the pores is a semi-cured product, since the filling rate of the resin is sufficiently high, when the composite sheet is bonded to another member by heating and pressing, the resin component sufficiently is exuded from the inside of the composite sheet. The resin component exuded in this manner contributes to the improvement of the adhesiveness, and the thermal resistance can be further reduced.

The nitride sintered body may contain a boron nitride sintered body. Boron nitride has high thermal conductivity, insulation, and the like. Therefore, the composite sheet containing the boron nitride sintered body can be suitably used as a component of semiconductor devices or the like.

According to an aspect of the present disclosure, there is provided a method for manufacturing a laminate including a laminating step of laminating a composite sheet obtained by the above-described method for manufacturing and a metal sheet and heating and pressing the composite sheet and the metal sheet. Since the laminate obtained by such a manufacturing method uses the above-described composite sheet, the laminate has excellent adhesion between the composite sheet and the metal sheets. Therefore, the laminate can reduce thermal resistance in the lamination direction.

**Advantageous Effects of Invention**

According to the present disclosure, it is possible to provide a composite sheet excellent in adhesion to other members and capable of reducing thermal resistance, and a manufacturing method of the composite sheet. Further, according to the present disclosure, it is possible to provide a laminate capable of reducing thermal resistance in a lamination direction by using such a composite sheet, and a manufacturing method of the laminate.

**Brief Description of Drawings**

[FIG. 1] FIG. 1 is a perspective view of a composite sheet according to an embodiment.
[FIG. 2] FIG. 2 is a cross-sectional view of a laminate according to an embodiment.

**Description of Embodiments**

Hereinafter, some embodiments of the present disclosure will be described with reference to the drawings as necessary. However, the following embodiments are examples for describing the present disclosure, and are not intended to limit the present disclosure to the following contents.

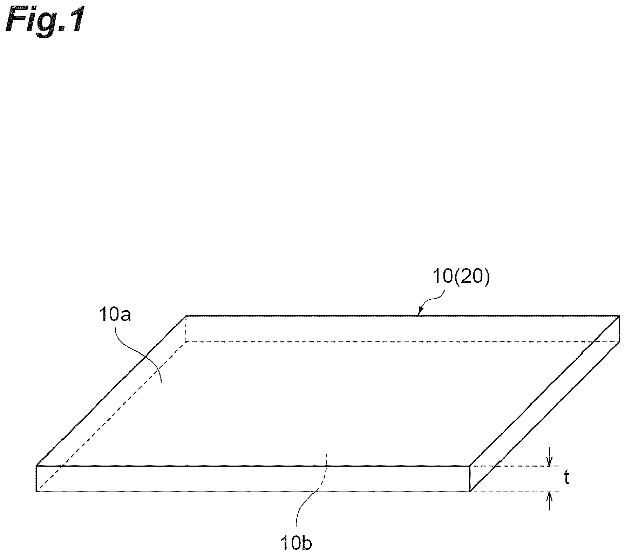

FIG. 1 is a perspective view of a composite sheet 10 according to an embodiment. The composite sheet 10 includes a porous nitride sintered body 20 having a thickness t of less than 2 mm and a resin filled in pores of the nitride sintered body 20. The nitride sintered body 20 contains nitride particles formed by the primary particles of the nitride being sintered together, and the pores. A main surface 10a and a main surface 10b of the composite sheet 10 have a maximum height roughness Rz of less than 20 $\mu$m. In the main surface 10a and the main surface 10b, a part of a main surface of the nitride sintered body 20 is exposed, and a recessed part of the main surface is embedded by resin. Thus, the main surface 10a and the main surface 10b are composed of the main surface of the nitride sintered body 20 and resin.

The maximum height roughness Rz in the main surface 10a and the main surface 10b may be less than 15 $\mu$m, or may be less than 12 $\mu$m. Thus, the main surface 10a and the main surface 10b can be sufficiently brought into close contact with another member. The other member may be, for example, a metal sheet, a cooling fin made of metal, or a metal circuit. The maximum height roughness Rz in the main surface 10a and the main surface 10b may be 1 $\mu$m or more, or may be 5 $\mu$m or more from the viewpoint of improving the adhesive force by the anchor effect.

The arithmetic average roughness Ra in the main surface 10a and the main surface 10b may be less than 1.4 $\mu$m, or may be less than 1.2 $\mu$m. Thus, the main surface 10a and the main surface 10b can be sufficiently brought into close contact with the other member. From the viewpoint of ease of production, the arithmetic average roughness Ra in the main surface 10a and the main surface 10b may be 0.2 $\mu$m or more, or may be 0.4 $\mu$m or more.

Both the main surface 10a and the main surface 10b are not necessarily within the range of the maximum height roughness Rz (arithmetic average roughness Ra) described above. In a modified example, at least one of the main surface 10a and the main surface 10b is within the range of the maximum height roughness Rz (arithmetic average roughness Ra) described above.

The maximum height roughness Rz and the arithmetic average roughness Ra in the present disclosure are surface roughness measured in accordance with ISO 25178, and can be measured under the following conditions using a commercially available measurement device (for example, a double scan high-precision laser measurement device LT-9000 manufactured by Keyence Corporation and a high-precision shape measurement system KS-1100 manufactured by the same company). The maximum height roughness Rz and the arithmetic average roughness Ra are obtained by scanning the entire main surface of the composite sheet with a laser at 500 $\mu$m/s and measuring the height at a pitch of 1 $\mu$m.

The resin filling rate in the composite sheet 10 may be 85% by volume or more. Accordingly, it is possible to reduce the amount of deformation at the time of bonding another member by heating and pressing. Therefore, the dimensional stability can be sufficiently enhanced. From the same viewpoint, the resin filling rate may be 88% by volume or more, may be 90% by volume or more, or may be 92% by volume or more.

The "resin" in the present disclosure may be a semi-cured product (B-stage) of a resin composition containing a main agent and a curing agent or a cured product (C-stage) in which curing is more advanced than the semi-cured product. The semi-cured product is a product in which a curing reaction of the resin composition partially proceeds. Accordingly, the semi-cured product may contain a thermosetting resin generated by the reaction of the main agent and the curing agent in the resin composition. The semi-cured product may contain monomers of the main agent, the curing agent, and the like in addition to the thermosetting resin as a resin component. It can be confirmed with, for example, a differential scanning calorimeter whether the resin contained in the composite sheet is the cured product (C-stage) or the semi-cured product (B-stage). The curing rate of the resin determined by the method described in Examples may be 10% to 70% or may be 20% to 60%.

In a case where the resin filled in the pores is a semi-cured product, if the filling rate of the resin is sufficiently high, the resin component is sufficiently exuded from the inside of the composite sheet 10 when bonded to another member by heating and pressing. The resin component exuded in this manner contributes to the improvement of the adhesiveness. Thus, the thermal resistance at the contact interface between the composite sheet 10 and the other member can be further reduced.

The resin may contain at least one selected from the group consisting of epoxy resin, silicone resin, cyanate resin, silicone rubber, acrylic resin, phenol resin, melamine resin, urea resin, bismaleimide resin, unsaturated polyester, fluororesin, polyimide, polyamideimide, polyetherimide, polybutylene terephthalate, polyethylene terephthalate, polyphenylene ether, polyphenylene sulfide, wholly aromatic polyester, polysulfone, liquid crystal polymer, polyethersulfone, polycarbonate, maleimide resin, maleimide-modified resin, acrylonitrile-butadiene-styrene (ABS) resin, acrylonitrile-acrylic rubber-styrene (AAS) resin, acrylonitrile-ethylene-propylene-diene rubber-styrene (AES) resin, polyglycolic acid resin, polyphthalamide, and polyacetal. The resin may contain one of them alone or may contain two or more of them in combination.

When the composite sheet 10 is used for an insulating layer of a printed wiring board, the resin may contain epoxy resin from the viewpoint of improving heat resistance and adhesive strength to a circuit. When the composite sheet 10 is used for a thermal interface material, the resin may contain silicone resin from the viewpoint of improving heat resistance, flexibility, and adhesion to a heat sink or the like.

The volume fraction of the resin in the composite sheet 10 may be 30 to 60% by volume, or 35 to 55% by volume, with respect to the total volume of the composite sheet 10. The volume fraction of the nitride particles constituting the nitride sintered body 20 in the composite sheet 10 may be 40 to 70% by volume, or 45 to 65% by volume, with respect to the total volume of the composite sheet 10. The composite sheet 10 having such a volume fraction can achieve both excellent adhesion and strength at high levels.

The average pore diameter of the pores of the nitride sintered body 20 may be 5 $\mu$m or less, 4 $\mu$m or less, or even 3.5 $\mu$m or less. In such a nitride sintered body 20, since the size of pores is small, the contact area between the nitride particles can be sufficiently increased. Therefore, the thermal resistance inside the composite sheet 10 can be sufficiently reduced. The average pore diameter of the pores of the nitride sintered body 20 may be 0.5 $\mu$m or more, 1 $\mu$m or more, or 1.5 $\mu$m or more. Since such a nitride sintered body 20 can be sufficiently deformed when pressurized at the time of bonding, the amount of exudation of the resin component can be increased when the resin component is a semi-cured product. Therefore, the adhesiveness can be further improved. An example of the average pore diameter of the pores is 0.5 to 5 $\mu$m.

The average pore diameter of pores in the nitride sintered body 20 can be measured by the following procedure. First, the composite sheet 10 is heated to remove the resin. Then, the pore diameter distribution when the nitride sintered body 20 is pressurized while increasing pressures from 0.0042 MPa to 206.8 MPa is obtained using a mercury-porosimeter. When the horizontal axis represents pore diameter and the vertical axis represents cumulative pore volume, the pore diameter at which the cumulative pore volume reaches 50% of the total pore volume is the average pore diameter. As the mercury-porosimeter, one manufactured by SHIMADZU CORPORATION can be used.

The porosity of the nitride sintered body 20, that is, the ratio of the volumes (V1) of pores in the nitride sintered body 20, may be 30 to 65% by volume, and may be 35 to 55% by volume. If the porosity is too large, the strength of the nitride sintered body 20 tends to decrease. On the other hand, if the porosity is too small, the amount of the resin exuded when the composite sheet 10 is bonded to another member tends to be small.

The porosity can be obtained by calculating a bulk density [B (kg/m$^3$)] from the volume and mass of the nitride sintered body 20 and with the following expression (1) from this bulk density and a theoretical density of nitride [A (kg/m$^3$)]. The nitride sintered body 20 may contain at least one selected from the group consisting of boron nitride, aluminum nitride, and silicon nitride. In the case of boron nitride, the theoretical density A is 2280 kg/m$^3$. In the case of aluminum nitride, the theoretical density A is 3260 kg/m$^3$. In the case of silicon nitride, the theoretical density A is 3170 kg/m$^3$.

$$\text{porosity (\% by volume)} = [1 - (B / A)] \times 100 \quad (1)$$

When the nitride sintered body 20 is a boron nitride sintered body, the bulk density B may be 800 to 1500 kg/m$^3$, or may be 1000 to 1400 kg/m$^3$. If the bulk density B becomes too small, the strength of the nitride sintered body 20 tends to decrease. On the other hand, if the bulk density B becomes too large, the amount of filled resin decreases, and the amount of the resin exuded when the composite sheet 10 is bonded to another member tends to decrease.

The thickness t of the nitride sintered body 20 may be less than 2 mm, or may be less than 1.6 mm. Such a composite sheet 10 including the nitride sintered body 20 can be reduced in size. In addition, even when the size is reduced, high heat dissipation performance can be maintained due to excellent adhesion to another member. From the viewpoint of facilitating the production of the nitride sintered body 20, the thickness t of the nitride sintered body 20 may be 0.1 mm or more, or may be 0.2 mm or more.

The thickness of the composite sheet 10 may be the same as the thickness t of the nitride sintered body 20 or may be larger than the thickness t of the nitride sintered body 20. The thickness of the composite sheet 10 may be less than 2 mm, or may be less than 1.6 mm. The thickness of the composite sheet 10 may be 0.1 mm or more, or may be 0.2 mm or more. The thickness of the composite sheet 10 is measured along a direction perpendicular to the main surfaces 10a and 10b. When the thickness of the composite sheet 10 is not constant, the thickness is measured by randomly selecting ten points, and the mean value thereof may be within the above-described range. When the thickness of the nitride sintered body 20 is not constant, the thickness is measured by randomly selecting ten points, and the mean value thereof is the thickness t. The size of the main surfaces 10a and 10b of the composite sheet 10 is not particularly limited, and may be, for example, 500 mm$^2$ or more, 800 mm$^2$ or more, or 1000 mm$^2$ or more.

The main surface 10a and the main surface 10b of the composite sheet 10 are preferably not cut surfaces.

Accordingly, the main surface 10a and the main surface 10b can be made sufficiently smooth, the adhesion to another member can be improved, and the thermal resistance at the contact interface between the composite sheet 10 and the other member can be sufficiently reduced.

Although the main surface 10a and the main surface 10b of the composite sheet 10 in the present embodiment have a square shape, the shape is not limited thereto. For example, the main surfaces may be a polygon other than a square, or may be a circle. The main surfaces may be a shape in which corner portions are chamfered or a shape in which a portion is cut out. The main surfaces may have a through hole penetrating in the thickness direction.

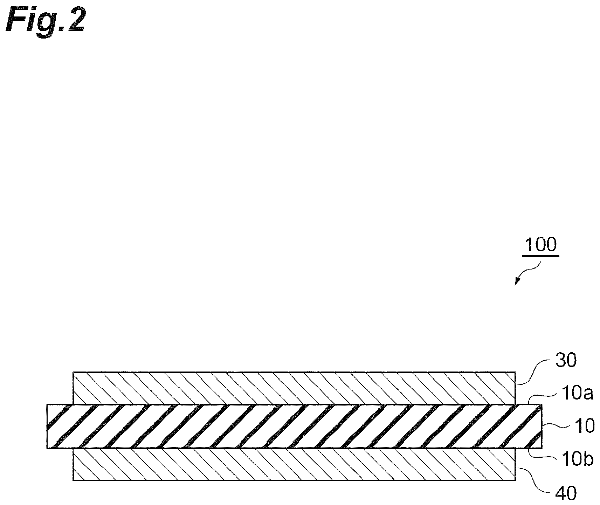

FIG. 2 is a cross-sectional view of a laminate 100 according to an embodiment taken along the thickness direction. The laminate 100 includes the composite sheet 10, a metal sheet 30 bonded to the main surface 10a of the composite sheet 10, and a metal sheet 40 bonded to the main surface 10b of the composite sheet 10. The metal sheets 30 and 40 may be a metallic plate or a metallic foil. Examples of the material of the metal sheets 30 and 40 include aluminum and copper. The material and thickness of the metal sheets 30 and 40 may be the same or different. It is not essential to include both of the metal sheets 30 and 40, and a modification of the laminated body 100 may include only one of the metal sheets 30 and 40.

The nitride sintered body contained in the composite sheet 10 constituting the laminate 100 may be in direct contact with the metal sheets 30 and 40. Since the laminate 100 includes the composite sheet 10 which is thin, the entire thickness can be reduced. Since the laminate 100 includes the composite sheet 10, thermal resistance at the contact interface between the composite sheet 10 and the metal sheet 30 and the contact interface between the composite sheet 10 and the metal sheet 40 can be sufficiently reduced. Therefore, the laminate 100 can sufficiently reduce thermal resistance in the lamination direction. Since such a laminate is thin and has sufficiently reduced thermal resistance, the laminate can be suitably used as, for example, a heat dissipation member in a semiconductor device or the like. The thermal resistance of the laminate 100 in the lamination direction, as measured according to ASTM D5470, may be 0.8 K/W or less, or may be 0.5 K/W or less.

A method for manufacturing a composite sheet according to an embodiment includes: a sintering step of preparing a porous nitride sintered body having a thickness of less than 2 mm; an impregnating step of impregnating pores of the nitride sintered body with a resin composition; a smoothing step of smoothing the resin composition adhering to a main surface of the nitride sintered body to obtain a resin-impregnated body in which a portion of the main surface of the nitride sintered body is exposed; and a curing step of heating the resin-impregnated body to cure or semi-cure the resin composition impregnated in the pores to obtain the composite sheet.

Raw material powder used in the sintering step contains nitride. The nitride contained in the raw material powder may contain, for example, at least one nitride selected from the group consisting of boron nitride, aluminum nitride, and silicon nitride. In the case where boron nitride is contained, the boron nitride may be amorphous boron nitride or hexagonal boron nitride. When a boron nitride sintered body is prepared as the nitride sintered body 20, for example, amorphous boron nitride powder having an average particle diameter of 0.5 to 10 $\mu$m or hexagonal boron nitride powder having an average particle diameter of 3.0 to 40 $\mu$m can be used as the raw material powder.

In the sintering step, blend containing the nitride powder may be molded and sintered to obtain the nitride sintered body. The molding may be carried out by uniaxial pressing or by cold isostatic pressing (CIP). Prior to molding, a sintering aid may be blended to obtain the blend. Examples of the sintering aid include metal oxides such as yttria oxide, aluminum oxide, and magnesium oxide; alkali metal carbonates such as lithium carbonate and sodium carbonate; and boric acid. When the sintering aid is blended, the blending amount of the sintering aid may be, for example, 0.01 parts by mass or more, or 0.1 parts by mass or more with respect to 100 parts by mass in total of the nitride and the sintering aid. The blending amount of the sintering aid may be, for example, 20 parts by mass or less, 15 parts by mass or less, or 10 parts by mass or less with respect to 100 parts by mass in total of the nitride and the sintering aid. When the amount of sintering aid added is within the above range, the average pore diameter of the nitride sintered body can be easily adjusted to the range described below.

The blend may be formed into a sheet-shaped molded body by a doctor blade method, for example. The molding method is not particularly limited, and a molded body may be obtained by performing press molding using a mold. The molding pressure may be, for example, 5 to 350 MPa. The shape of the molded body may be a sheet shape having a thickness of less than 2 mm. When a nitride sintered body is produced using such a sheet-shaped molded body, a sheet-shaped composite sheet having a thickness of less than 2 mm can be produced without cutting the nitride sintered body. In addition, compared to a case in which a block-shaped molded body or a block-shaped nitride sintered body is cut into a sheet shape, the main surface of the composite sheet can be smoothed. In addition, material loss due to processing can be reduced. Therefore, the composite sheet having a smooth main surface can be manufactured with a high yield.

The sintering temperature in the sintering step may be, for example, 1600°C or more, or may be 1700°C or more. The sintering temperature may be, for example, 2200°C or less, or may be 2000°C or less. The sintering time may be, for example, 1 hour or more and 30 hours or less. The atmosphere during sintering may be, for example, an inert gas atmosphere such as nitrogen, helium, and argon.

For the sintering, for example, a batch furnace, a continuous furnace, or the like can be used. Examples of the batch furnace include a muffle furnace, a tubular furnace, and an atmospheric furnace. Examples of the continuous furnace include a rotary kiln, a screw conveyor furnace, a tunnel furnace, a belt furnace, a pusher furnace, and a large continuous furnace. In this way, the nitride sintered body can be obtained. The nitride sintered body may be block-shaped.

When the nitride sintered body has a block shape, a cutting step of processing the nitride sintered body to have a thickness less than 2 mm is performed. In the cutting step, the nitride sintered body is cut using, for example, a wire saw. The wire saw may be, for example, a multi-cut wire saw or the like. By such a cutting step, for example, a sheet-like nitride sintered body having a thickness of less than 2 mm can be obtained. The nitride sintered body thus obtained has a cut surface.

When the cutting step of the nitride sintered body is performed, fine cracks may be generated in the cut surface. On the other hand, since the composite sheet obtained without performing the cutting step of the nitride sintered body does not have a cut surface, fine cracks can be sufficiently reduced and a smooth main surface can be easily obtained. Therefore, the composite sheet obtained without performing the cutting step of the nitride sintered body is likely to be excellent in adhesion to other members. Further, when processing such as cutting is performed, material loss occurs. Therefore, the composite sheet having no cut surface of the nitride sintered body can reduce the material loss. Accordingly, the yield of the nitride sintered body and the composite sheet can be improved.

In the impregnating step, pores of the nitride sintered body having a thickness of less than 2 mm are impregnated with a resin composition to obtain the resin-impregnated body. Since the nitride sintered body is in the form of a sheet having a thickness of less than 2 mm, the resin composition is easily impregnated into the inside thereof. In addition, the resin filling rate can be sufficiently increased by adjusting the viscosity of the resin composition impregnated into the nitride sintered body to be within a range suitable for impregnation. When the main surface of the nitride sintered body is impregnated by dropping the resin composition, the dropping amount of the resin composition on the main surface of the nitride sintered body may be 1.1 times or more, or 1.3 times or more of the total volume of the pores of the boron nitride sintered body from the viewpoint of sufficiently increasing the filling rate of the resin in the pores. The dropping amount may be 2 times or less, or may be 1.8 times or less of the total volume of pores of the boron nitride sintered body from the viewpoint of reducing manufacturing costs.

The viscosity of the resin composition when the nitride sintered body is impregnated with the resin composition may be 440 mPa s or less, may be 390 mPa·s or less, or may be 340 mPa·s or less. By lowering the viscosity of the resin composition in this manner, impregnation of the resin composition can be sufficiently promoted. The viscosity of the resin composition when the nitride sintered body is impregnated with the resin composition may be 15 mPa·s or more, and may be 20 mPa s or more. By setting the lower limit to the viscosity of the resin composition in this manner, the resin composition once impregnated into the pores can be prevented from flowing out from the pores. The viscosity of the resin composition may be adjusted by partially polymerizing the monomer components by heating. The viscosity of the resin composition is a viscosity at a temperature T1 of the resin composition when the nitride sintered body 20 is impregnated with the resin composition. The viscosity is measured using a rotational viscometer at a shear rate of 10 (1/sec) under temperature T1 conditions. Accordingly, the viscosity of the resin composition when the nitride sintered body is impregnated with the resin composition may be adjusted by changing the temperature T1.

The temperature T1 when the nitride sintered body is impregnated with the resin composition may be, for example, equal to or higher than a temperature T2 at which the resin composition is cured and lower than a temperature T3 (= T2 + 20°C). The temperature T2 may be, for example, 80 to 140°C. Impregnation of the nitride sintered body with the resin composition may be performed under pressure or reduced pressure. The impregnation method is not particularly limited, and may be performed by immersing the nitride sintered body 20 in the resin composition or by applying the resin composition to the main surfaces of the nitride sintered body.

The impregnating step may be performed under either a reduced pressure condition or a pressurized condition, or may be performed by combining impregnation under a reduced pressure condition and impregnation under a pressurized condition. When the impregnating step is carried out under the reduced pressure condition, the pressure in an impregnation apparatus may be, for example, 1000 Pa or less, 500 Pa or less, 100 Pa or less, 50 Pa or less, or 20 Pa or less. When the impregnating step is performed under the pressurized condition, the pressures in the impregnation apparatus may be, for example, 1 MPa or more, 3 MPa or more, 10 MPa or more, or 30 MPa or more.

Impregnation of the resin composition by the capillary phenomenon may be promoted by adjusting the pore diameter of the pores in the nitride sintered body. From such a viewpoint, the average pore diameter of the nitride sintered body 20 may be 0.5 to 5 $\mu$m, and may be 1 to 4 $\mu$m.

As the resin composition, for example, a composition which becomes the resin described in the description of the composite sheet through a curing or semi-curing reaction can be used. The resin composition may contain a solvent. The viscosity of the resin composition may be adjusted by changing the blending amount of the solvent, or the viscosity of the resin composition may be adjusted by partially advancing the curing reaction. Examples of the solvent include aliphatic alcohols such as ethanol and isopropanol, ether alcohols such as 2-methoxyethanol, 1-methoxyethanol, 2-ethoxyethanol, 1-ethoxy-2-propanol, 2-butoxyethanol, 2-(2-methoxyethoxy)ethanol, 2-(2-ethoxyethoxy)ethanol, 2-(2-butoxyethoxy)ethanol, and the like, glycol ethers such as ethylene glycol monomethyl ether, ethylene glycol monobutyl ether, and the like, ketones such as acetone, methyl ethyl ketone, methyl isobutyl ketone, diisobutyl ketone, and the like, and hydrocarbons such as toluene, xylene, and the like. The solvent may contain one of them alone or may contain two or more of them in combination.

The resin composition is thermosetting and may contain, for example, at least one compound selected from the group consisting of a compound having a cyanate group, a compound having a bismaleimide group, and a compound having an epoxy group, and a curing agent.

Examples of the compound having a cyanate group include dimethylmethylene bis(1,4-phenylene)biscyanate, bis(4-cyanatephenyl)methane, and the like. Dimethylmethylene bis(1,4-phenylene)biscyanate is commercially available, for example, as, TACN (manufactured by MITSUBISHI GAS CHEMICAL COMPANY, INC., trade name).

Examples of the compound having a bismaleimide group include N,N'-[(1-methylethylidene)bis[(p-phenylene)oxy(p-phenylene)]]bismale imide, 4,4'-diphenylmethane bismaleimide, and the like. N,N'-[(1-methylethylidene)bis[(p-phenylene)oxy(p-phenylene)]]bismale imide is commercially available, for example, as BMI-80 (manufactured by K.I Chemical Industry Co., Ltd., trade name).

Examples of the compound having an epoxy group include a bisphenol F type epoxy resin, a bisphenol A type epoxy resin, a biphenyl type epoxy resin, a polyfunctional epoxy resin, and the like. For example, 1,6-bis(2,3-epoxypropan-1-yloxy)naphthalene or the like that is commercially available as HP-4032D (manufactured by DIC Corporation, trade name) may be exemplified.

The curing agent may include a phosphine-based curing agent and an imidazole-based curing agent. The phosphine-based curing agent may promote a triazine-generating reaction by trimerization of the compound having a cyanate group or a cyanate resin. Examples of the phosphine-based curing agent include tetraphenyl phosphonium tetra-p-tolyl borate, tetraphenyl phosphonium tetraphenyl borate, and the like. Tetraphenyl phosphonium tetra-p-tolyl borate is commercially available, for example, as TPP-MK (manufactured by HOKKO CHEMICAL INDUSTRY CO., LTD., trade name).

The imidazole-based curing agent generates oxazoline and promotes a curing reaction of the compound having an epoxy group or an epoxy resin. Examples of the imidazole-based curing agent include 1-(1-cyanomethyl)-2-ethyl-4-methyl-1H-imidazole, 2-ethyl-4-methylimidazole, and the like. 1-(1-Cyanomethyl)-2-ethyl-4-methyl-1H-imidazole is commercially available, for example, as 2E4MZ-CN (manufactured by SHIKOKU CHEMICALS CORPORATION, trade name).

The content of the phosphine-based curing agent may be, for example, 5 parts by mass or less, 4 parts by mass or less, or 3 parts by mass or less, with respect to 100 parts by mass of the total amount of the compound having a cyanate group, the compound having a bismaleimide group, and the compound having an epoxy group. The content of the phosphine-based curing agent may be, for example, 0.1 parts by mass or more or 0.5 parts by mass or more, with respect to 100 parts by mass of the total amount of the compound having a cyanate group, the compound having a bismaleimide group, and the compound having an epoxy group. When the content of the phosphine-based curing agent is within the above range, the resin-impregnated body can be easily prepared, and the time required for bonding the composite sheet cut out from the resin-impregnated body to another member can be further shortened.

The content of the imidazole-based curing agent may be, for example, 0.1 parts by mass or less, 0.05 parts by mass or less, or 0.03 parts by mass or less, with respect to 100 parts by mass of the total amount of the compound having a cyanate group, the compound having a bismaleimide group, and the compound having an epoxy group. The content of the imidazole-based curing agent may be, for example, 0.001 parts by mass or more or 0.005 parts by mass or more, with respect to 100 parts by mass of the total amount of the compound having a cyanate group, the compound having a bismaleimide group, and the compound having an epoxy group. When the content of the imidazole-based curing agent is within the above range, the resin-impregnated body can be easily prepared.

The resin composition may contain components other than the main agent and the curing agent. As the other components, for example, at least one selected from the group consisting of other resins such as a phenol resin, a melamine resin, a urea resin, and an alkyd resin, a silane coupling agent, a leveling agent, an antifoaming agent, a surface conditioner, a wetting dispersant, and the like may be further contained. The content of these other components may be, for example, 20% by mass or less, 10% by mass or less, or 5% by mass or less in total, with respect to the total amount of the resin composition.

In the smoothing step, the resin composition adhering to the main surface of the nitride sintered body is smoothed. The resin-impregnated body may be prepared by removing a portion of the resin composition from the main surface. The smoothing of the resin composition may be performed using at least one selected from the group consisting of a leveling member, a polishing member, and a polishing device. The leveling member is a member capable of leveling resin composition adhering to the main surface of the nitride sintered body and extending the resin composition on the main surface. Examples of the leveling member include a scraper, a paper wiper, and a rubber spatula. Examples of the polishing member include a grindstone and sandpaper. Examples of the polishing device include a blasting device that performs alumina blasting or the like. By a method using such a member or device, it is possible to smoothly reduce the unevenness of the main surface and adjust the surface roughness.

**EP 4 191 664 A1**

A method of smoothing the resin composition adhering to the main surface of the nitride sintered body is not limited to the above-described method. For example, a portion of the resin composition may be removed using a solvent, hot water, or hot air that is compatible with the resin composition. The smoothing (removal) of the resin composition may be performed by any one of these methods or may be performed by combining a plurality of methods. Examples of the solvent compatible with the resin composition include the above-described solvents contained in the resin composition. The hot water may be 80°C or higher, and may be 90°C or higher. The hot air may be 100°C or more, and may be 120°C or more. The hot air may blow off the resin composition by blowing air using a blower, for example.

The smoothing step is followed by a curing step of curing or semi-curing the resin composition impregnated in the pores. In the curing step, the resin composition is semi-cured by heating and/or light irradiation depending on the type of the resin composition (or curing agent added as necessary). "Semi-cured" (also referred to as B-stage) refers to those that can be further cured by a subsequent curing treatment. The composite sheet and the metal sheets may be temporarily pressure-bonded to other members such as the metal sheets by utilizing the semi-cured state, and then heated to bond the composite sheet and the metal sheets. The semi-cured product may be further cured into a "fully cured" (also referred to as a C-stage) state. This makes it difficult for the composite sheet to be deformed, so that it is possible to stably maintain the dimensions when the composite sheet is connected to other members.

In the curing step, when the resin composition is semi-cured by heating, the heating temperature may be, for example, 80 to 130°C. The cured product (semi-cured product) obtained by curing (semi-curing) the resin composition may contain, as the resin component, at least one thermosetting resin selected from the group consisting of a cyanate resin, a bismaleimide resin, and an epoxy resin, and a curing agent. The semi-cured product may contain, as a resin component, components derived from, for example, other resins such as a phenol resin, a melamine resin, a urea resin, and an alkyd resin, as well as a silane coupling agent, a leveling agent, an antifoaming agent, a surface conditioner, a wetting dispersant, and the like.

The composite sheet obtained in this manner has a thickness of, for example, 2 mm or less. Therefore, it is thin and lightweight, and when it is used as a component of semiconductor devices or the like, the devices can be made compact and lightweight. In addition, since the main surface of the composite sheet is sufficiently smooth and the main surface of the nitride sintered body is sufficiently exposed, it is possible to improve adhesion between another member bonded to the main surface of the composite sheet and the nitride sintered body and to sufficiently reduce thermal resistance. Further, in the above-described manufacturing method, the composite sheet can be manufactured without cutting the nitride sintered body. Therefore, a composite sheet having excellent reliability can be manufactured at a high yield. The composite sheet may be laminated with metal sheets to form a laminate, or may be used as a heat dissipation member as it is. The composite sheet 10 illustrated in FIG. 1 may be manufactured by the manufacturing method described above.

A method for manufacturing a laminate according to an embodiment includes a lamination step of laminating a composite sheet and metal sheets, and heating and pressing the composite sheet and the metal sheets. The composite sheet may be manufactured by the above-described manufacturing method. The metal sheets may be metal plates or may be metal foils.

In the lamination step, the metal sheet is arranged on the main surfaces of the composite sheet. While the main surfaces of the composite sheet and the metal sheet are brought into contact with each other, the composite sheet and the metal sheet are pressurized and heated in a direction in which the main surfaces face each other. Pressurization and heating do not necessarily need to be performed at the same time, and heating may be performed after pressurization and pressure bonding. The pressurizing force may be, for example, 2 to 10 MPa. In this case, when the temperature at which the resin composition is semi-cured is T2, a heating temperature T4 may satisfy $T4 \geq T2 + 20°C$, or may satisfy $T4 \geq T2 + 40°C$. Accordingly, the composite sheet and the metal sheet can be firmly bonded to each other. From the viewpoint of preventing decomposition of the cured product, the heating temperature T4 may satisfy $T4 \leq T2 + 150°C$ and may satisfy $T4 \leq T2 + 100°C$.

The laminate thus obtained can be used for manufacturing semiconductor devices or the like. A semiconductor element may be provided on one metal sheet. Another metal sheet may be joined with cooling fins. The laminate 100 illustrated in FIG. 2 may be manufactured by the manufacturing method described above.

Although several embodiments have been described above, the present disclosure is not limited to the above-described embodiments. For example, in the sintering step, a nitride sintered body may be obtained by hot pressing in which molding and sintering are simultaneously performed.

[Example]

The contents of the present disclosure will be more specifically described with reference to Examples and Comparative Examples; however, the present disclosure is not limited to the following Examples.

9

(Example 1)

<Production of nitride sintered body>

100 parts by mass of orthoboric acid manufactured by Nippon Denko Co., Ltd. and 35 parts by mass of acetylene black (trade name: HS100) manufactured by Denka Company Limited were mixed using a Henschel mixer. The obtained mixture was filled in a graphite crucible and heated in an arc furnace in an argon atmosphere at 2200°C for 5 hours to obtain lump boron carbide ($B_4C$). The obtained lump product was coarsely pulverized with a jaw crusher to obtain a coarse powder. This coarse powder was further pulverized with a ball mill having silicon carbide beads ($\phi$10 mm) to obtain a pulverized powder.

The prepared pulverized powder was filled in a boron nitride crucible. Thereafter, the crucible was heated for 10 hours using a resistance heating furnace in a nitrogen gas atmosphere under the conditions of 2000°C and 0.85 MPa. In this way, a fired product containing boron carbonitride ($B_4CN_4$) was obtained.

Powdery boric acid and calcium carbonate were blended to prepare a sintering aid. Upon the preparation, 45.0 parts by mass of calcium carbonate was blended with respect to 100 parts by mass of boric acid. Regarding the atomic ratio of boron and calcium at this time, the atomic ratio of calcium was 15.5 atom% with respect to 100 atom% of boron. 20 parts by mass of the sintering aid was blended with respect to 100 parts by mass of the fired product and mixed using a Henschel mixer to prepare a powdery blend.

The blend was pressurized using a powder pressing machine at 150 MPa for 30 seconds to obtain a molded body having a sheet shape (length × width × thickness = 50 mm × 50 mm × 0.45 mm). The molded body was put in a boron nitride container and introduced into a batch-type high-frequency furnace. In the batch-type high-frequency furnace, heating was performed for 5 hours under the conditions of normal pressure, a nitrogen flow rate of 5 L/min, and 2000°C. Thereafter, a boron nitride sintered body was extracted from the boron nitride container. In this way, a sheet-shaped (quadrangular prism-shaped) boron nitride sintered body was obtained. The thickness of the boron nitride sintered body was 0.5 mm. The thickness t was measured with a caliper.

<Measurement of porosity>

The volume and mass of the obtained boron nitride sintered body were measured, and the bulk the density B ($kg/m^3$) were calculated from the volumes and masses. From this bulk density B and the theoretical density ($2280 \ kg/m^3$) of boron nitride, the porosity was obtained by the following expression (2). Results were as shown in Table 1.

$$\text{Porosity (\% by volume)} = [1 - (B \, / \, 2280)] \times 100 \qquad (2)$$

<Production of composite sheet>

A resin composition was prepared by blending 10 parts by mass of a commercially available curing agent (manufactured by Nippon Synthetic Chemical Industry Co., Ltd., trade name: Akumex H-8) with 100 parts by mass of a commercially available epoxy resin (manufactured by Mitsubishi Chemical Corporation, trade name: Epikote 807). The prepared resin composition was heated at 120°C for 15 minutes, and then dropped onto the main surface on the upper side of the boron nitride sintered body heated to 120°C by using a dropper while maintaining the temperature to impregnate the resin composition. The dropping amount of the resin composition was 1.3 times the total volume of pores of the boron nitride sintered body. A portion of the resin composition did not permeate the boron nitride sintered body and remained on the main surface.

Under atmospheric pressure, the resin composition remaining on the main surface on the upper side of the boron nitride sintered body was smoothed using a stainless steel scraper (manufactured by Nalby Inc.). Excess resin composition was removed to obtain a resin-impregnated body having a smooth main surface.

The resin-impregnated body was heated at 160°C for 30 minutes under atmospheric pressure to semi-cure the resin composition. In this manner, a quadrangular prism-shaped composite sheet (length × width × thickness = 50 mm × 50 mm × 0.5 mm) was produced. The size of the composite sheet was measured with a caliper. The boron nitride sintered body was exposed in a part of the main surface of the composite sheet.

The curing rate of the resin constituting the semi-cured product was determined by the following procedure. First, the temperature of one gram of resin composition before curing (uncured) was raised, and a calorific value Q (J/g) generated until complete curing was measured using a differential scanning calorimeter. Next, the temperature of one gram of composite sheet was similarly raised, and the calorific value R (J/g) generated until complete curing was measured using the same differential scanning calorimeter. The composite sheet was heated at 600°C for 1 hour to volatilize the resin component, and a content c (% by weight) of the thermosetting components contained in the composite sheet was determined from the difference in weight before and after heating.

Using the calorific values Q, R, and the content c obtained by the above-described procedure, the curing rate of the resins contained in the composite sheet was obtained by the following expression (3). As a result, the curing rate of the resin was 36%.

$$\text{Curing rate (\%)} = \{1 - [(R / c) \times 100] / Q\} \times 100 \qquad (3)$$

<Measurement of maximum height roughness Rz and arithmetic average roughness Ra>

The maximum height roughness Rz and arithmetic average roughness Ra of the main surface smoothed with a stainless steel scraper were measured. Rz and Rz are surface roughness measured in accordance with ISO 25178. For the measurement, a double-scan high-precision laser measuring device LT-9000 (trade name) manufactured by Keyence Corporation and a high-precision shape measuring system KS-1100 (trade name) manufactured by the same company were used. The maximum height roughness Rz and the arithmetic average roughness Ra were obtained by scanning the entire main surface of the composite sheet with a laser at 500 $\mu$m/s and measuring the height at a pitch of 1 $\mu$m. Results were as shown in Table 1.

<Measurement of filling rate of resin (semi-cured product)>

The filling rate of the resin contained in the composite sheet was obtained by the following expression (4). Results were as shown in Table 1.

$$\text{resin filling rate (\% by volume) in the composite sheet} = \{(\text{bulk density of composite sheet - bulk density of boron nitride sintered body}) / (\text{theoretical density of composite sheet - bulk density of boron nitride sintered body})\} \times 100 \quad (4)$$

The bulk densities of the boron nitride sintered body and the composite sheet were determined in accordance with JIS Z 8807:2012 "Method for measuring density and specific gravity by geometric measurement" based on the volume calculated from the length of each side of the boron nitride sintered body or the composite sheet (measured with a caliper) and the mass of the boron nitride sintered body or the composite sheet measured with an electronic balance (see JIS Z 8807:2012, section 9). The theoretical density of the composite sheet was obtained by the following expression (5)

$$\text{Theoretical density of composite sheet} = \text{true density of boron nitride sintered body} + \text{true density of resin} \times (1 - \text{bulk density of boron nitride sintered body / true density of boron nitride}) \quad (5)$$

The true densities of the boron nitride sintered body and the resin were determined from the volumes and masses of the boron nitride sintered body and the resin measured using a dry automatic density meter in accordance with "Method for measuring density and specific gravity by gas displacement method" in JIS Z 8807:2012 (see expressions (14) to (17) in section 11 of JIS Z 8807:2012).

<Preparation of laminate>

The above-described composite sheet (length $\times$ width $\times$ thickness = 50 mm $\times$ 20 mm $\times$ 0.5 mm) was disposed between a sheet-shaped copper foil (length $\times$ width $\times$ thickness = 100 mm $\times$ 20 mm $\times$ 0.035 mm) and a sheet-shaped copper plate (length $\times$ width $\times$ thickness = 100 mm $\times$ 20 mm $\times$ 1 mm) to prepare a laminate including the copper foil, the composite sheet, and the copper plate in this order. The laminate was heated and pressurized at 200°C and 5 MPa for 5 minutes, and then heat-treated at 200°C and atmospheric for 2 hours. Thus, the laminate was obtained.

<Evaluation of thermal resistance>

The thermal resistance of the laminate in the lamination direction was measured in accordance with ASTM-D5470. For the measurement, a resin material thermal resistance measuring device (manufactured by Hitachi Technologies and Services, Ltd.) was used. Based on the thermal resistance (unit: K/W) of the laminate prepared by using the composite sheet obtained in Comparative Example 1, the thermal resistance of the laminate prepared by using the composite sheet obtained in Example 1 was evaluated as a relative value as follows. Results were as shown in Table 1.

A: The relative value was less than 0.8 when the thermal resistance of Comparative Example 1 was set to 1
B: The relative value was 0.8 or more and less than 1 when the thermal resistance of Comparative Example 1 was set to 1.
C: The relative value was 1 or more when the thermal resistance of Comparative Example 1 was set to 1.

(Example 2)

A composite sheet was produced in the same manner as in Example 1 except that hot air at 100°C was used instead of the scraper. That is, hot air (air) of 100°C was blown to the resin composition on the main surface on the upper side of the boron nitride sintered body using a blower to smooth the resin composition on the main surface. Excess resin composition was blown off to prepare a resin-impregnated body having a smooth main surface. In the same manner as in Example 1, each measurement of the composite sheet and production and evaluation of the laminate were performed. Results were as shown in Table 1.

(Example 3)

A composite sheet was produced in the same manner as in Example 1 except that sandpaper (particle size defined by JIS R6010 (2000): P2000) was used instead of the scraper. That is, the resin composition on the main surface on the upper side of the boron nitride sintered body was smoothed using the sandpaper described above to prepare a resin-impregnated body having a smooth main surface. In the same manner as in Example 1, each measurement of the composite sheet and production and evaluation of the laminate were performed. Results were as shown in Table 1.

(Example 4)

A composite sheet was produced in the same manner as in Example 1 except that a paper wiper (manufactured by Nippon Paper Crecia Co., Ltd.) was used instead of the scraper. That is, the resin composition on the main surface on the upper side of the boron nitride sintered body was wiped using a paper wiper to be smoothed. Excess resin composition was removed to prepare a resin-impregnated body having a smooth main surface. In the same manner as in Example 1, each measurement of the composite sheet and production and evaluation of the laminate were performed. Results were as shown in Table 1.

(Example 5)

A composite sheet was produced in the same manner as in Example 1 except that hot water at about 100°C was used instead of the scraper. That is, the resin composition was coated on the upper main surface of the boron nitride sintered body nitride sintered body and then immersed in hot water for 5 minutes. As a result, excess resin composition on the main surface was washed away to prepare a resin-impregnated body having a smooth main surface. Using the resin-impregnated body taken out from hot water, each measurement of the composite sheet and production and evaluation of the laminate were performed in the same manner as in Example 1. Results were as shown in Table 1.

(Example 6)

A composite sheet was produced in the same manner as in Example 1 except that a solvent (acetone) at about 20°C was used instead of the scraper. That is, the resin composition was coated on the upper main surface of the boron nitride sintered body, and then immersed in a solvent at about 20°C for 5 minutes. As a result, excess resin composition on the main surface was washed away to prepare a resin-impregnated body having a smooth main surface. By using the resin-impregnated body taken out from the solvent, each measurement of the composite sheet and production and evaluation of the laminate were performed in the same manner as in Example 1. Results were as shown in Table 1.

(Comparative Example 1)

In the same procedure as in Example 1, a sintered product containing boron carbonitride ($B_4CN_4$) and a sinter aid were prepared, and these were blended to prepare a powdery blend. This blend was pressed with 150 MPa for 30 seconds using a powder press machine to obtain a block-shaped molded body (length × width × thickness = 50 mm × 50 mm × 48 mm). This compact was placed in a boron nitride container and introduced into a batch-type high-frequency furnace. In a batch-type high-frequency oven, heating was performed for 5 hours under conditions of atmospheric pressure, nitrogen flow rate of 5 L/min, and 2000°C. Thereafter, the boron nitride sintered body was taken out from the boron nitride container. In this manner, a block-shaped (quadrangular prism-shaped) boron nitride sintered body was obtained. The size of the boron nitride sintered body was length × width × thickness = 50 mm × 50 mm × 50 mm. The porosity of the obtained boron nitride sintered body was measured by the same procedure as in Example 1. Results were as shown in Table 1.

A resin composition was prepared in the same manner as in Example 1, and the resin composition was added dropwise to one upper surface of the boron nitride sintered body to impregnate the boron nitride sintered body with the resin composition, thereby obtaining a block-shaped resin-impregnated body. The dropping amount of the resin composition was 1.3 times the total volume of pores of the boron nitride sintered body.

The resin-impregnated body was heated at 160°C for 30 minutes under atmospheric pressure to semi-cure the resin composition, thereby obtaining a block-shaped composite. The composite was cut along the thickness-wise direction using a multi-cut wire saw to produce 70 thin plate-shaped composite sheets having a thickness of 0.5 mm. One composite sheet in which both main surfaces were cut surfaces was selected, and the maximum height roughness Rz, arithmetic average roughness Ra of the main surface and the filling rate of the resin were measured. Each measurement was performed in the same manner as in Example 1. Using this composite sheet, a laminate was produced in the same manner as in Example 1, and thermal resistance was evaluated. Results were as shown in Table 1.

Table 1

|  | boron nitride sintered body | composite sheet | | | laminate |
|---|---|---|---|---|---|
|  | porosity [% by volume] | Rz [μm] | Ra [μm] | filling rate [% by volume] | thermal resistance |
| Example 1 | 55 | 9.5 | 1.0 | 95 | A |
| Example 2 | 54 | 9.2 | 0.8 | 97 | A |
| Example 3 | 49 | 10.1 | 0.9 | 96 | A |
| Example 4 | 53 | 8.9 | 1.1 | 94 | A |
| Example 5 | 52 | 9.4 | 1.0 | 98 | B |
| Example 6 | 55 | 10.3 | 0.9 | 95 | B |
| Comparative Example 1 | 56 | 32.1 | 1.6 | 97 | C |

In each of the composite sheets of Examples 1 to 6 and Comparative Example 1, the boron nitride sintered body was exposed in a part of the main surface. The other portion of the main surface was covered with resin. The maximum height roughness Rz of the main surface of the composite sheet of each of Examples 1 to 6 was considerably smaller than the maximum height roughness Rz of the main surface of the composite sheet of Comparative Example 1. The laminate produced using the composite sheets of Examples 1 to 6 had sufficiently low thermal resistance.

**Industrial Applicability**

According to the present disclosure, a composite sheet excellent in adhesion to other members and capable of reducing thermal resistance and a manufacturing method thereof are provided. According to the present disclosure, a laminate capable of reducing thermal resistance in a lamination direction by using such a composite sheet, and a manufacturing method thereof are provided.

**Reference Signs List**

10: composite sheet, 10a, 10b: main surface, 20: nitride sintered body, 30, 40: metal sheet, 100: laminate.

**Claims**

1. A composite sheet comprising:

   a porous nitride sintered body having a thickness less than 2 mm; and
   a resin filled in pores of the nitride sintered body,
   wherein the composite sheet comprises a main surface having a maximum height roughness Rz of less than 20 μm.

2. The composite sheet according to claim 1, wherein a filling rate of the resin in the pores is 85% by volume or more.

3. The composite sheet according to claim 1 or 2, wherein the nitride sintered body contains a boron nitride sintered body.

4. A laminate comprising the composite sheet according to any one of claims 1 to 3 and a metal sheet laminated to each other.

5. A method for manufacturing a composite sheet, the method comprising:

   an impregnating step of impregnating pores of a porous nitride sintered body having a thickness of less than 2 mm with a resin composition;
   a smoothing step of smoothing the resin composition adhering to a main surface of the nitride sintered body to obtain a resin-impregnated body in which a portion of the main surface is exposed; and
   a curing step of heating the resin-impregnated body to cure or semi-cure the resin composition impregnated in the pores to obtain the composite sheet.

6. The method for manufacturing the composite sheet according to claim 5, wherein in the smoothing step, the resin composition adhering to the main surface of the nitride sintered body is smoothed using at least one selected from a group consisting of a leveling member, a polishing member, a polishing apparatus, hot water, a solvent compatible with the resin composition, and hot air.

7. The method for manufacturing the composite sheet according to claim 5 or 6, wherein in the curing step, the composite sheet having a main surface having a maximum height roughness Rz of less than 20 μm is obtained.

8. The method for manufacturing the composite sheet according to any one of claims 5 to 7, wherein a filling rate of the resin of the composite sheet obtained in the curing step is 85 % by volume or more.

9. The method for manufacturing the composite sheet according to any one of claims 5 to 8, wherein the nitride sintered body contains a boron nitride sintered body.

10. A method for manufacturing a laminate comprising a laminating step of laminating the composite sheet obtained by the method for manufacturing according to any one of claims 5 to 9 and a metal sheet, and heating and pressing the composite sheet and the metal sheet.

*Fig.1*

10(20)

10a

10b

t

# Fig.2

## INTERNATIONAL SEARCH REPORT

| International application No. |
|---|
| **PCT/JP2021/035424** |

### A.    CLASSIFICATION OF SUBJECT MATTER

*H01L 23/36*(2006.01)i; *H01L 23/373*(2006.01)i
FI:    H01L23/36 M; H01L23/36 C; H01L23/36 D

According to International Patent Classification (IPC) or to both national classification and IPC

### B.    FIELDS SEARCHED

Minimum documentation searched (classification system followed by classification symbols)

H01L23/36; H01L23/373

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

### C.    DOCUMENTS CONSIDERED TO BE RELEVANT

| Category* | Citation of document, with indication, where appropriate, of the relevant passages | Relevant to claim No. |
|---|---|---|
| X | WO 2018/181606 A1 (DENKA CO., LTD.) 04 October 2018 (2018-10-04)<br>paragraphs [0001], [0019]-[0048], fig. 1-3 | 1-10 |
| X | JP 2019-145744 A (IBIDEN CO., LTD.) 29 August 2019 (2019-08-29)<br>paragraphs [0006], [0019]-[0056], fig. 1 | 5-6, 8-9 |
| A | | 1-4, 7, 10 |
| A | WO 2017/155110 A1 (DENKA CO., LTD.) 14 September 2017 (2017-09-14)<br>paragraphs [0001], [0035]-[0082] | 1-10 |
| A | WO 2014/196496 A1 (DENKI KAGAKU KOGYO KK) 11 December 2014 (2014-12-11)<br>paragraphs [0030]-[0087] | 1-10 |
| A | JP 5-82760 B2 (IBIDEN CO., LTD.) 22 November 1993 (1993-11-22)<br>column 4, line 38 to column 10, line 6 | 1-10 |

☐ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **09 November 2021** | **22 November 2021** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2021/035424**

| Patent document cited in search report | | | Publication date (day/month/year) | Patent family member(s) | | | Publication date (day/month/year) |
|---|---|---|---|---|---|---|---|
| WO | 2018/181606 | A1 | 04 October 2018 | US paragraphs [0001], [0031]-[0075], fig. 1-3 | 2020/0031723 | A1 | |
| | | | | EP | 3605602 | A1 | |
| | | | | CN | 110168719 | A | |
| | | | | KR | 10-2019-0132395 | A | |
| JP | 2019-145744 | A | 29 August 2019 | (Family: none) | | | |
| WO | 2017/155110 | A1 | 14 September 2017 | US paragraphs [0001], [0044]-[0101] | 2019/0092695 | A1 | |
| | | | | EP | 3428223 | A1 | |
| | | | | KR | 10-2018-0124915 | A | |
| | | | | CN | 109153801 | A | |
| WO | 2014/196496 | A1 | 11 December 2014 | US paragraphs [0010]-[0110] | 2016/0130187 | A1 | |
| | | | | EP | 3006419 | A1 | |
| | | | | CN | 105263886 | A | |
| | | | | KR | 10-2016-0016857 | A | |
| JP | 5-82760 | B2 | 22 November 1993 | US column 2, line 41 to column 6, line 21 | 4882455 | A | |
| | | | | EP | 196865 | A2 | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2014196496 A
- JP 2016103611 A